# EUROPÄISCHE PATENTANMELDUNG

(11) **EP 2 325 490 A1**
(43) Veröffentlichungstag der Anmeldung: **25.05.2011**
(21) Anmeldenummer: 10012025.2
(22) Anmeldetag: 30.09.2010
(51) Int. Cl.: F04B 43/00, B81B 3/00, G01B 7/00, B29C 70/88

(54) **Sensierende Membran**

(30) Priorität: 06.11.2009 DE 102009052244
(71) Anmelder: Carl Freudenberg KG, 69469 Weinheim (DE)
(72) Erfinder: Diekmann, Hans-Jürgen, 69488 Birkenau (DE); Stephan, Ingo, 64668 Rimbach (DE); Trares, Werner, 64649 Heppenheim (DE); Uhl, Daniel, 69488 Birkenau (DE)

(57) **Zusammenfassung**

Eine Anordnung, umfassend mindestens einen Sensor (7, 8), ein deformierbares Element (1) und eine Einrichtung (11) zur Erfassung und Auswertung der vom Sensor (7, 8) erfassten und ausgegebenen Signale, ist im Hinblick auf die Aufgabe, eine Anordnung der eingangs genannten Art derart auszugestalten und weiterzubilden, dass bei einfachem Aufbau eine zuverlässige Erkennung von Schadstellen eines deformierbaren Elements ermöglicht ist, **dadurch gekennzeichnet, dass** das deformierbare Element (1) ein Magnetfeld (9) erzeugt und der Sensor (7, 8) Änderungen des Magnetfeldes (9) erfasst.

## Beschreibung

### Beschreibung

### Technisches Gebiet

Die Erfindung betrifft eine Anordnung, umfassend mindestens einen Sensor, ein deformierbares Element und eine Einrichtung zur Erfassung und Auswertung der vom Sensor erfassten und ausgegebenen Signale.

### Stand der Technik

Aus dem Stand der Technik sind eine Vielzahl von Anordnungen bekannt, die der Beobachtung von deformierbaren Elementen dienen. Häufig werden Betriebszustände der deformierbaren Elemente durch direkten Kontakt mit diesen überwacht. Dabei ist denkbar, dass ein deformierbares Element mit elektrischen, hydraulischen oder pneumatischen Anschlüssen versehen ist.

Insbesondere bei Lebensmittelpumpen und Chemiepumpen besteht allerdings ein Bedarf nach einer zuverlässigen Überwachung der Betriebszustände von Membranen in einem geschlossenen Pumpengehäuse. Die Membranen befinden sich dabei meist in Kontakt mit zu fördernden Medien. Die zu fördernden Medien können chemisch aggressiv oder sehr empfindlich gegen Verschmutzungen sein.

Daher werden solche Membranen häufig vorsorglich ausgewechselt, um zu verhindern, dass durch schadhafte Membranen Kontaminationen der Umgebung oder des Mediums auftreten.

Hierbei ist allerdings nachteilig, dass Membranen nur in aufwendiger Weise ausgewechselt werden können. Hierzu muss das Pumpengehäuse geöffnet, das Medium entfernt und die Membran ausgebaut werden. Dabei kann es vorkommen, dass eine noch voll betriebstaugliche Membran ausgebaut wird, die noch viele Betriebsstunden zuverlässig abgedichtet hätte.

### Darstellung der Erfindung

Der Erfindung liegt daher die Aufgabe zu Grunde, eine Anordnung der eingangs genannten Art derart auszugestalten und weiterzubilden, dass bei einfachem Aufbau eine zuverlässige Erkennung von Schadstellen eines deformierbaren Elements ermöglicht ist.

Erfindungsgemäß wird die voranstehende Aufgabe mit den Merkmalen des Patentanspruchs 1 gelöst.

Danach ist die eingangs genannte Anordnung dadurch gekennzeichnet, dass das deformierbare Element ein Magnetfeld erzeugt und der Sensor Änderungen des Magnetfeldes erfasst.

Erfindungsgemäß ist zunächst erkannt worden, dass ein Magnetfeld eine kontaktlose Überwachung eines deformierbaren Elements erlaubt, ohne dass am deformierbaren Element Anschlüsse angebracht werden müssen. Insoweit wird der Aufbau der Anordnung stark vereinfacht. Die kontaktlose Messung erlaubt insbesondere eine Verwendung des deformierbaren Elements in aggresiven Medien, da die Feldlinien des Magnetfelds die Medien problemlos durchlaufen. Des Weiteren ist überraschend erkannt worden, dass ein Sensor, welcher Magnetfeldstärken misst, mit sehr hoher Auflösung schon kleinste Schäden eines deformierbaren Elements erkennen kann. Überraschend können Risse und Spalte im Mikrometerbereich detektiert werden. Insoweit ist eine sehr zuverlässige Überwachung eines deformierbaren Elements auf Schadstellen realisiert.

Folglich ist die eingangs genannte Aufgabe gelöst.

Das deformierbare Element könnte mindestens eine magnetfelderzeugende Schicht aus Kunststoff aufweisen, in welche magnetisierte Partikel eingebettet sind. Bei einer Rissbildung in einem Kunststoff werden benachbarte Partikel durch eine Deformierung des Elements stärker beabstandet als dies bei einem intakten Element der Fall wäre. Die vergrößerte Beabstandung benachbarter Partikel beidseits eines Risses führt zu einer messbaren Änderung des Magnetfelds im deformierten Zustand.

Dabei ist konkret denkbar, dass das deformierbare Element aus einer einzigen magnetfelderzeugenden Schicht besteht. In einen Kunststoff oder eine Polymermischung können problemlos Strontiumferritpartikel, Eisenpartikel, Ferrite und weitere Partikel eingearbeitet werden, die nach der Einarbeitung magnetisiert werden können. Hierdurch wird der Schicht aus Kunststoff ein charakteristisches Magnetfeld aufgeprägt. Des Weiteren ist ein Kunststoff leicht und kann derart gewählt werden, dass er gegen aggressive Medien chemisch stabil ist. Schließlich kann ein Kunststoff derart ausgewählt werden, dass er zerstörungsfrei deformiert werden kann.

Vor diesem Hintergrund könnte die magnetfelderzeugende Schicht aus einem Elastomer gefertigt sein. Elastomere sind problemlos reversibel und elastisch deformierbar. Elastomere schmiegen sich des Weiteren an bestehende Strukturen und Halterungen dichtend an. Insoweit kann das deformierbare Element zwei Räume gegeneinander abdichten und insbesondere in Pumpen verwendet werden.

Das deformierbare Element könnte mindestens eine magnetfelderzeugende Schicht aus einem Vliesstoff aufweisen, in welchen magnetisierte Partikel eingebettet sind. In einen Vliesstoff lassen sich aufgrund dessen Porosität besonders leicht magnetische oder magnetisierbare Partikel einarbeiten. Des Weiteren kann ein Vliesstoff aus Kunststofffasem problemlos mit einer Elastomerlage laminiert werden. Vor diesem Hintergrund könnte der Vliesstoff zwischen einer Schicht aus einem Elastomer und einer Beschichtung aus Polytetrafluorethylen positioniert sein. Ein Vliesstoff zeigt in einem Verbund mit Elastomeren eine geringere mechanische Stabilität gegen Deformierungen als die anderen Verbundpartner. Daher werden die Partikel in einem Vliesstoff leichter und weiter voneinander beabstandet als in einem Elastomer. Insoweit kann ein Schaden am Element besonders effektiv nachgewiesen werden.

Das deformierbare Element könnte mindestens eine Verstärkungsschicht aus einem Gewebe oder einem ähnlichen Material aufweisen. Hierdurch kann die Bruchfestigkeit des Kunststoffs oder Elastomers verstärkt werden, wenn das deformierbare Element andauernden Biegebelastungen unterworfen wird. Dabei ist denkbar, dass das Gewebe oder das ähnliche Material sandwichartig zwischen einer Schicht aus einem Elastomer und einer Schicht aus Polytetrafluorethylen aufgenommen ist. Dabei können eine oder beide der Schichten und/ oder das Gewebe magnetisierte Partikel enthalten.

Das hier beschriebene deformierbare Element könnte als hubbewegliche Membran ausgestaltet sein, die in ihrem Randbereich an Einspannstellen eingespannt ist. Hierdurch kann das deformierbare Element in Membranpumpen, insbesondere in Lebensmittelpumpen oder Chemiepumpen eingesetzt werden. Das deformierbare Element kann als Hubmittel fungieren. Vor diesem Hintergrund könnte die Membran einen Gewindestummel aufnehmen. Der Gewindestummel kann mit einem Exzenterantrieb verbunden werden, welcher die Membran zu Hubbewegungen auslenkt und dabei deformiert.

Die Membran könnte eine Beschichtung aus Polytetrafluorethylen aufweisen. Polytetraflourethylen ist gegen die meisten aggressiven Medien chemisch stabil. Es kann daher die Membran in einer Membranpumpe gegen die zu fördernden Medien schützen.

Die hier beschriebene Anordnung könnte in einem Verfahren zur Erkennung von Rissen in der Oberfläche eines deformierbaren Elements verwendet werden. Bei einer Rissbildung in einem Kunststoff werden benachbarte Partikel durch eine Deformierung des Elements stärker beabstandet als dies bei einem intakten Element der Fall wäre. Die vergrößerte Beabstandung benachbarter Partikel beidseits eines Risses führt zu einer messbaren Änderung des Magnetfelds im deformierten Zustand, Insoweit können zuverlässig entstehende oder bestehende Schadstellen des deformierbaren Elements erfasst werden.

Das deformierbare Element könnte von einem ersten Zustand in einen zweiten Zustand deformiert werden, wobei ein Ausgangsmagnetfeld im ersten Zustand durch die Deformation in den zweiten Zustand in ein Deformationsmagnetfeld geändert wird und wobei je zwei aufeinanderfolgende Ausgangsmagnetfelder und/ oder Deformationsmagnetfelder verglichen werden. Wenn sich zwischen zwei oder mehr aufeinanderfolgenden Hüben des deformierbaren Elements bzw. einer Membran ein Riss oder Risse gebildet haben, wird das Magnetfeld im deformierten Zustand der Membran, das sogenannte Deformationsmagnetfeld, bei einer schadhaften Membran gegenüber einer intakten Membran geändert. Durch Vergleich der Magnetfelder der intakten Membran mit später gemessenen Magnetfeldem kann auf Risse geschlossen werden.

Es könnten Risse mit einer Breite ab 1 µm detektiert werden. Hierdurch ist eine sehr hohe Auflösung gegeben. Zur Erzielung einer so hohen Auflösung kann der Sensor als Hall-Sensor, Fluxgate-Sensor MR-Sensor oder GMR-Sensor ausgestaltet sein. Denkbar ist auch, in einer Anordnung mehrere Sensoren zu verwenden.

Die hier beschriebene Anordnung eignet sich besonders für eine Verwendung in einer Pumpe, insbesondere in einer Membranpumpe. Die hier beschriebene Anordnung kann nämlich auch verwendet werden, um Hubvolumina, Arbeitstakte, Durchflussmengen, geleistete Hubarbeiten, Informationen über die Antriebsbelastung eines Pumpenantriebs, Ausfälle des Pumpenmotors, Brüche in der Hubmechanik, einen Bruch des Gewindestummels und/ oder Lagerspiele zu erfassen, zu signalisieren und gegebenenfalls zu quantifizieren. Weiter kann der Abstand der Membran relativ zum Pumpenkopf erfasst werden.

Denkbar ist auch eine Verwendung der hier beschriebenen Anordnung im Qualitätsmanagement, um Schäden an Bauteilen zu erfassen und zu signalisieren.

Es gibt nun verschiedene Möglichkeiten, die Lehre der vorliegenden Erfindung auf vorteilhafte Weise auszugestalten und weiterzubilden. Dazu ist einerseits auf die nachgeordneten Ansprüche, andererseits auf die nachfolgende Erläuterung bevorzugter Ausführungsbeispiele der Erfindung anhand der Zeichnung zu verweisen.

In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert.

### Kurzbeschreibung der Zeichnung

In der Zeichnung zeigen
- Fig. 1: eine schematische Ansicht einer Anordnung mit drei Sensoren und einem deformierbaren Element, welches als Membran einer Membranpumpe ausgestaltet ist,
- Fig. 2: eine schematische Ansicht einer Membran, in welcher ein Riss ausgebildet ist,
- Fig. 3: ein strahlenförmiges Magnetisierungsmuster, welches dem deformierbaren Element aufgeprägt ist,
- Fig. 4: ein sternförmiges Magnetisierungsmuster, welches dem deformierbaren Element aufgeprägt ist,
- Fig. 5: ein flächiges Magnetisierungsmuster, welches dem deformierbaren Element aufgeprägt ist,
- Fig. 6: ein aus konzentrischen Ringen bestehendes Magnetisierungsmuster, welches dem deformierbaren Element aufgeprägt ist,
- Fig. 7: ein weiteres, aus konzentrischen Ringen bestehendes Magnetisierungsmuster, welches dem deformierbaren Element
- Fig. 8: aufgeprägt ist, wobei die Abstände zwischen den Ringen zum Zentrum hin abnehmen, ein punktförmiges Magnetisierungsmuster, welches dem deformierbaren Element aufgeprägt ist,
- Fig. 9: ein weiteres, aus konzentrischen Ringen bestehendes Magnetisierungsmuster, welches dem deformierbaren Element aufgeprägt ist, wobei die Abstände zwischen den Ringen zum Zentrum hin zunehmen,
- Fig. 10: ein weiteres flächiges Magnetisierungsmuster, welches dem deformierbaren Element aufgeprägt ist und
- Fig. 11: ein schachbrettartiges Magnetisierungsmuster, welches dem deformierbaren Element kreisförmig aufgeprägt ist.

### Ausführung der Erfindung

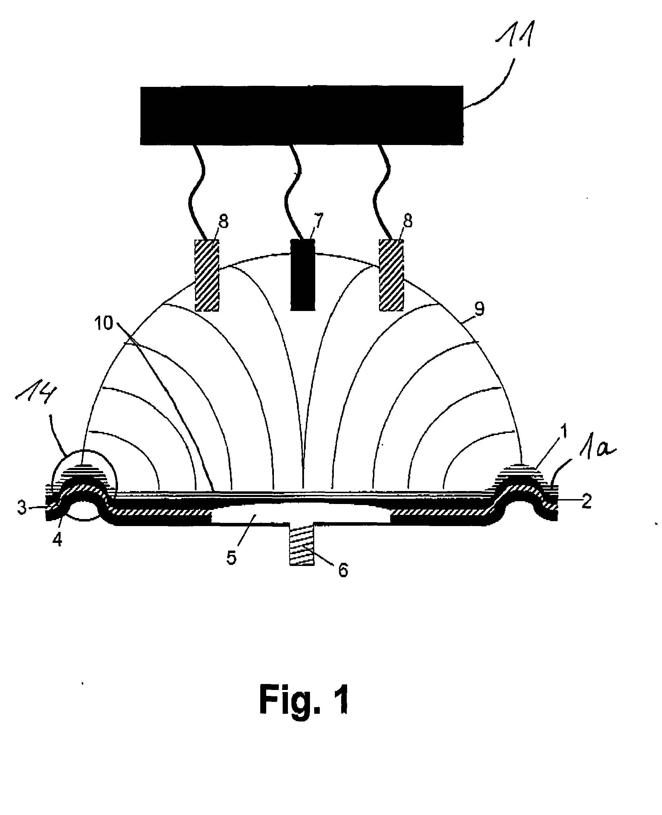

Fig. 1 zeigt in einer schematischen Ansicht eine Anordnung mit einem deformierbaren Element 1, welches aus vier Schichten 1a, 2, 3, 4 besteht. Das deformierbare Element 1 weist eine magnetfelderzeugende Schicht 2 aus Kunststoff auf, in welche magnetisierte Partikel eingebettet sind. Die Schicht 1a ist als Beschichtung aus Polytetrafluorethylen ausgestaltet. Die Schicht 2 ist aus einem Elastomer gefertigt. Das deformierbare Element 1 weist eine Verstärkungsschicht 3 aus einem Gewebe auf. Hierdurch kann die Bruchfestigkeit des Elastomers verstärkt werden, wenn das deformierbare Element 1 andauernden Biegebelastungen unterworfen wird.

In das deformierbare Element 1 ist ein Kern 5 mit einem Gewindestummel 6 eingearbeitet. Der Gewindestummel 6 wird mit einem nicht gezeigten Exzenterantrieb verbunden, um das deformierbare Element 1 in Hubbewegungen zu versetzen. Das deformierbare Element 1 fungiert hierbei als Membran einer Membranpumpe.

Durch die Hubbewegungen wird die Membran stark belastet, so dass es zu Schäden in der magnetfelderzeugenden Schicht 2 kommen kann. Gewöhnlich treten zuerst Schäden an der oberen magnetfelderzeugenden Schicht 2 auf. Diese Schäden werden von mindestens einem der Sensoren 7, 8 erfasst, bevor es zu einem vollständigen Durchbruch der Membran kommt. Hierzu ist die magnetfelderzeugende Schicht 2 mit magnetisierten Partikeln befüllt, die ein charakteristisches Magnetfeld 9 erzeugen.

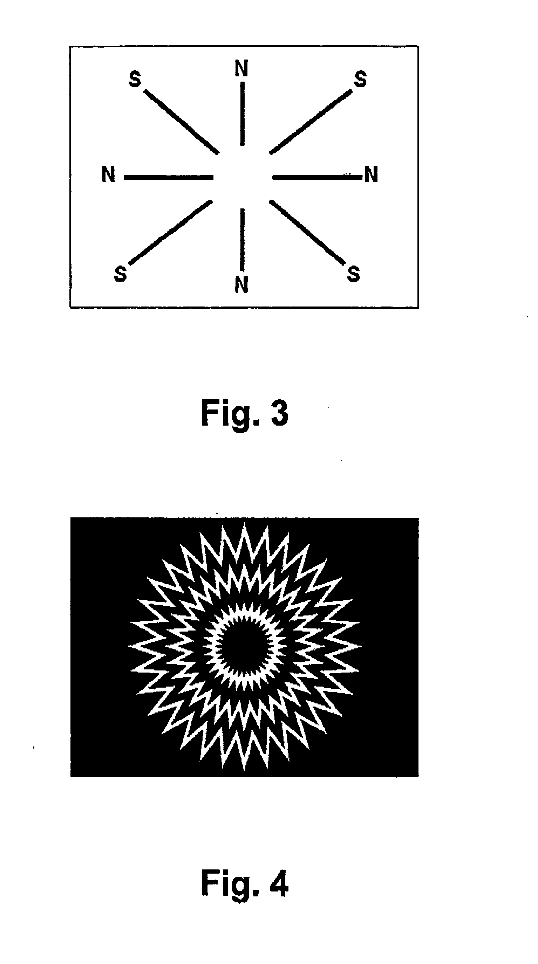

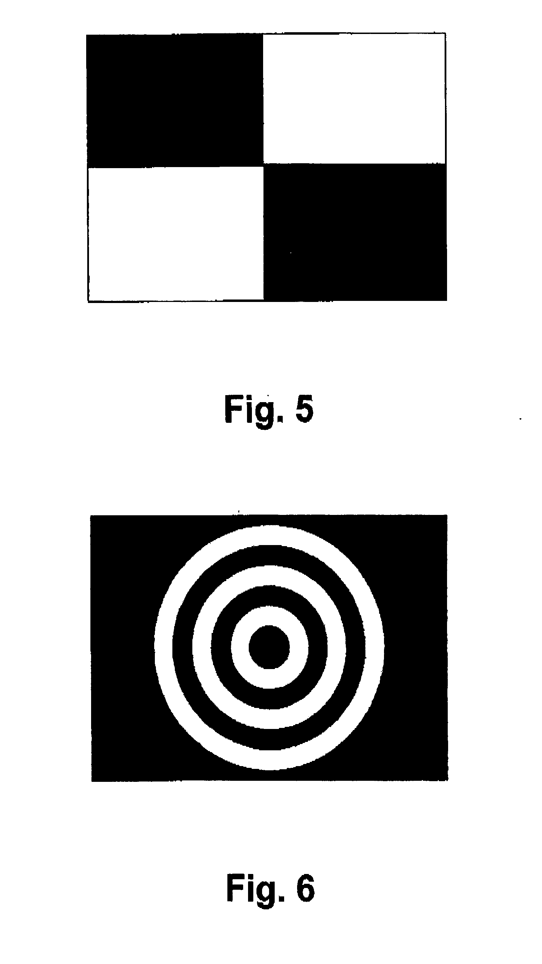

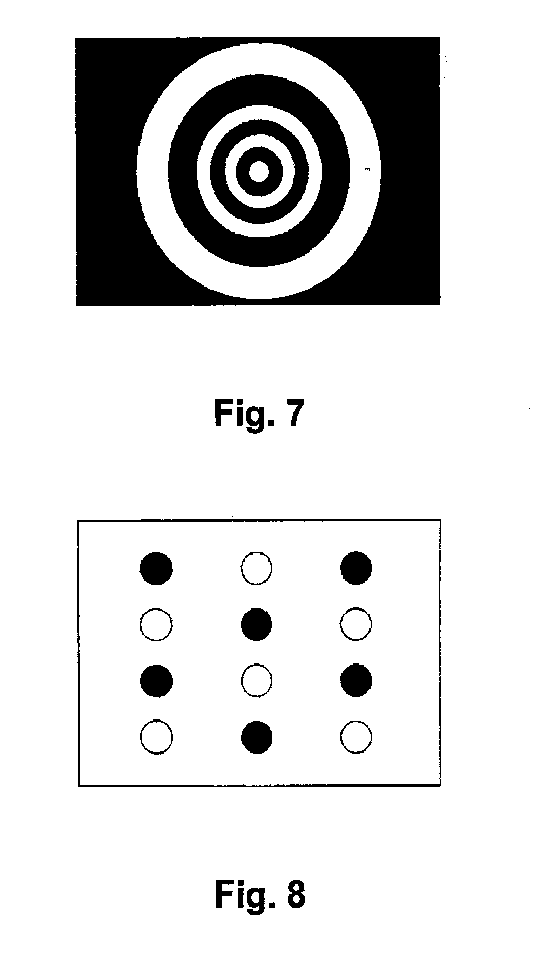

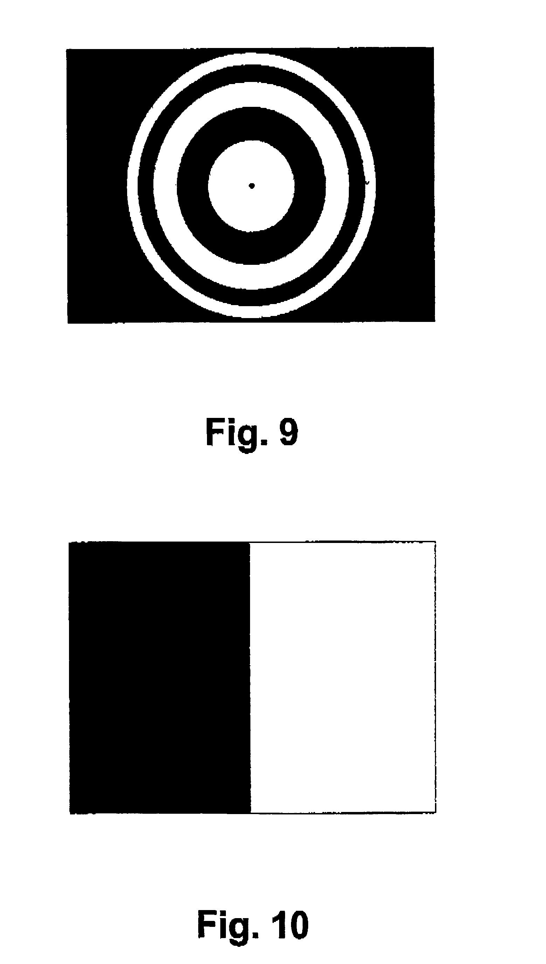

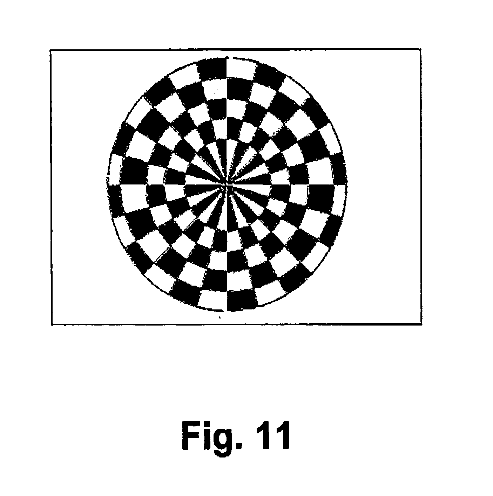

Dem Magnetfeld 9 können die in den Fig. 3 bis 11 gezeigten Magnetisierungsmuster zugrunde liegen. Die Magnetisierungsmuster der Fig. 3 bis 11 wurden den Partikeln in der magnetfelderzeugenden Schicht 2 durch ein externes Magnetfeld aufgezwungen.

Die Sensoren 7, 8 erfassen die Magnetfeldstärke des Magnetfeldes 9. Die Magnetfeldstärke des Magnetfeldes 9 ist vom Abstand der Oberfläche 10 der Membran zu den Sensoren 7, 8 und von der Geometrie des Magnetfeldes 9 abhängig. Das Magnetisierungsmuster der Membran ist dabei so ausgewählt, dass bei einer Hubbewegung der Membran von den Sensoren 7, 8 eindeutige, charakteristische Signale erfasst und ausgegeben werden. Eine Einrichtung 11, die über eine Auswerteelektronik verfügt, erfasst die von den Sensoren 7, 8 erfassten und ausgegebenen Signale und wertet diese aus.

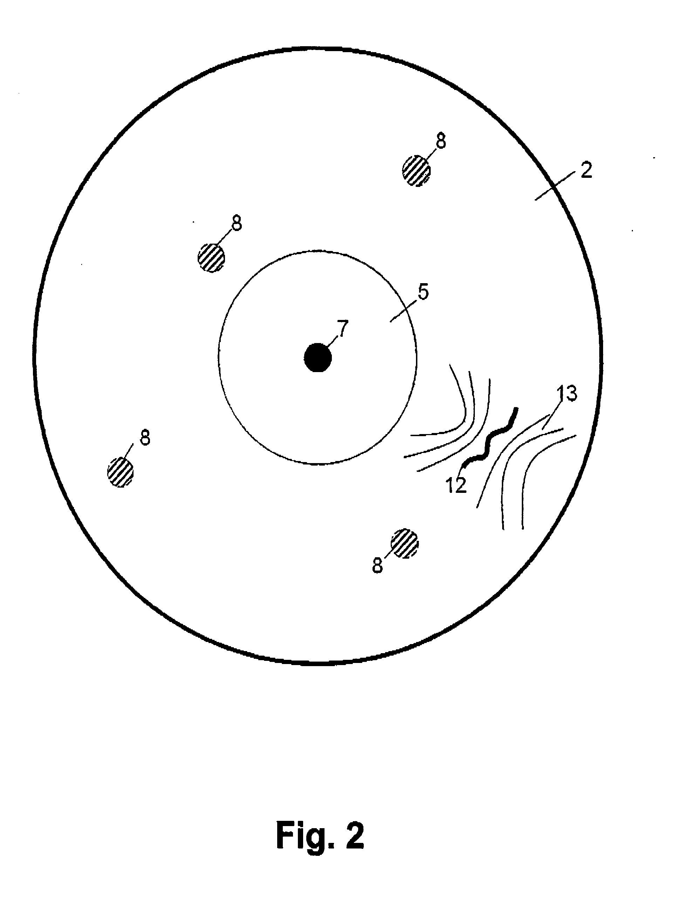

Die Einrichtung 11 nimmt die Signale der Sensoren 7, 8 kontinuierlich auf und ermittelt Abweichungen im Verlauf der Signale der Sensoren 7, 8 mindestens zweier aufeinander folgender Hubbewegungen. Wenn eine Abweichung ein zuvor eingestelltes Toleranzband überschreitet, gibt die Einrichtung 11 eine Warnung aus. Die Warnung zeigt an, dass eine Änderung im Magnetfeld 9 stattgefunden hat. Diese Änderung kann durch einen Riss 12 hervorgerufen werden, wie er in Fig. 2 schematisch gezeigt ist.

Fig. 2 zeigt einen Riss 12, der zu einer unnormalen Beabstandung magnetischer oder magnetisierter Partikel in der magnetfelderzeugenden Schicht 2 führt. Die unnormale Beabstandung der Partikel führt dann zu einem zuvor von der der Einrichtung 11 nicht ermittelten Verlauf der Signale der Sensoren 7, 8. Der Riss 12 wird begleitet von Falten 13, die dort entstehen, wo die magnetfelderzeugende Schicht 2 an Einspannstellen 14 angebunden ist.

Die Fig. 3 bis 11 zeigen charakteristische Magnetisierungen der magnetfelderzeugenden Schicht 2. Dem Magnetfeld 9 einer magnetfelderzeugenden Schicht 2 können die in den Fig. 3 bis 11 gezeigten Magnetisierungsmuster zugrunde liegen. Die Magnetisierungsmuster der Fig. 3 bis 11 wurden den Partikeln in der magnetfelderzeugenden Schicht 2 durch ein externes Magnetfeld aufgezwungen. Es ist aber auch denkbar, permanentmagnetische Partikel in die magnetfelderzeugende Schicht 2 einzubetten.

Hinsichtlich weiterer vorteilhafter Ausgestaltungen und Weiterbildungen der erfindungsgemäßen Lehre wird einerseits auf den allgemeinen Teil der Beschreibung und andererseits auf die Patentansprüche verwiesen.

Abschließend sei ganz besonders hervorgehoben, dass die zuvor ausgewählten Ausführungsbeispiele lediglich zur Erörterung der erfindungsgemäßen Lehre dienen, diese jedoch nicht auf diese Ausführungsbeispiele einschränken.

## Patentansprüche

1. Anordnung, umfassend mindestens einen Sensor (7, 8), ein deformierbares Element (1) und eine Einrichtung (11) zur Erfassung und Auswertung der vom Sensor (7, 8) erfassten und ausgegebenen Signale,
**dadurch gekennzeichnet, dass** das deformierbare Element (1) ein Magnetfeld (9) erzeugt und der Sensor (7, 8) Änderungen des Magnetfeldes (9) erfasst.

2. Anordnung nach Anspruch 1, **dadurch gekennzeichnet, dass** das deformierbare Element (1) mindestens eine magnetfelderzeugende Schicht (2, 4) aus Kunststoff aufweist, in welche magnetisierte Partikel eingebettet sind.

3. Anordnung nach Anspruch 2, **dadurch gekennzeichnet, dass** die magnetfelderzeugende Schicht (2, 4) aus einem Elastomer gefertigt ist.

4. Anordnung nach einem der Ansprüche 1 bis 3, **dadurch gekennzeichnet, dass** das deformierbare Element (1) mindestens eine magnetfelderzeugende Schicht (2, 4) aus einem Vliesstoff aufweist, in welchen magnetisierte Partikel eingebettet sind.

5. Anordnung nach einem der Ansprüche 1 bis 4, **dadurch gekennzeichnet, dass** das deformierbare Element (1) mindestens eine Verstärkungsschicht (3) aus einem Gewebe aufweist.

6. Anordnung nach einem der Ansprüche 1 bis 5, **dadurch gekennzeichnet, dass** das deformierbare Element (1) als hubbewegliche Membran ausgestaltet ist, die in ihrem Randbereich an Einspannstellen (14) eingespannt ist.

7. Anordnung nach Anspruch 6, **dadurch gekennzeichnet, dass** die Membran einen Gewindestummel (6) aufnimmt.

8. Anordnung nach einem der Ansprüche 1 bis 7, **dadurch gekennzeichnet, dass** das deformierbare Element (1) eine Beschichtung (1a) aus Polytetrafluorethylen aufweist.

9. Verfahren zur Erkennung von Rissen (12) in der Oberfläche (10) eines deformierbaren Elements (1), wobei eine Anordnung nach einem der voranstehenden Ansprüche verwendet wird.

10. Verfahren nach Anspruch 9, **dadurch gekennzeichnet, dass** das deformierbare Element (1) von einem ersten Zustand in einen zweiten Zustand deformiert wird, wobei ein Ausgangsmagnetfeld im ersten Zustand durch die Deformation in den zweiten Zustand in ein Deformationsmagnetfeld geändert wird, und wobei je zwei aufeinanderfolgende Ausgangsmagnetfelder und/ oder Deformationsmagnetfelder verglichen werden.

11. Verfahren nach Anspruch 10, **dadurch gekennzeichnet, dass** Risse (12) ab einer Breite von 1 µm detektiert werden.

12. Verwendung einer Anordnung nach einem der Ansprüche 1 bis 8 in einer Pumpe.
